# EUROPEAN PATENT APPLICATION

(11) **EP 1 746 173 A2**
(43) Date of publication of application: **24.01.2007**
(21) Application number: 06251827.9
(22) Date of filing: 31.03.2006
(51) Int. Cl.: C22C 19/00

(54) **Enhanced sputter target manufacturing method**

(30) Priority: 23.11.2005 US 284911; 22.07.2005 US 701546
(71) Applicant: Heraeus, Inc., Chandler AZ 85226 (US)
(72) Inventor: Ziani, Abdelouahab, Chandler, AZ 85226 (US); Kunkel, Bernd, Phoenix, AZ 85048 (US)
(74) Representative: Hill, Justin John

(57) **Abstract**

A method of manufacturing a sputter target the method including the step of preparing a plurality of raw materials into a composition corresponding to alloy system, the plurality of raw materials comprising pure elements or master alloys. The method also includes the step of heating the plurality of raw materials under vacuum or under a partial pressure of argon (Ar) to a fully liquid state to form a molten alloy corresponding to the alloy system, solidifying the molten alloy to form an ingot, and reheating the ingot to a fully liquid state to form a diffuse molten alloy. The method further includes the steps of rapidly solidifying the diffuse molten alloy into a homogeneous pre-alloyed powder material, admixing pure elemental powders to the homogeneous pre-alloyed powder material, consolidating the homogeneous pre-alloyed powder material into a fully dense homogeneous material, hot rolling the fully dense homogeneous material. Moreover, the method includes the steps of cold rolling the fully dense homogeneous material, and machining the fully dense homogenous material to form a sputter target.

## Description

### FIELD OF THE INVENTION

The present invention application generally relates to sputter targets and, more particularly, relates to a solidification process which produces sound billet stocks for manufacturing defect-free, chemically homogeneous sputter targets with enhanced pass through flux ("PTF").

### DESCRIPTION OF THE RELATED ART

The process of DC magnetron sputtering is widely used in a variety of fields to provide thin film material deposition of a precisely controlled thickness and within narrow atomic fraction tolerances on a substrate, for example to coat semiconductors and/or to form films on surfaces of magnetic recording media. In one common configuration, a racetrack-shaped magnetic field is applied to the sputter target by placing magnets on the backside surface of the target. Electrons are trapped near the sputter target, improving argon ion production and increasing the sputtering rate. Ions within this plasma collide with a surface of the sputter target causing the sputter target to emit atoms from the sputter target surface. The voltage difference between the cathodic sputter target and an anodic substrate that is to be coated causes the emitted atoms to form the desired film on the surface of the substrate.

Typically, cobalt (Co), chromium (Cr), iron (Fe), and nickel (Ni) alloy based sputter targets are manufactured by conventional ingot metallurgy processes. As an unintended side-effect of these processes, solute redistribution at the solidification front and convection in the liquid phase may cause a severe chemical segregation in the as-cast product. Furthermore, gas porosity from as-cast ingots is another consequence, since gas entrapment occurs during the casting operation, and no hot working processes are available to seal off gas pores.

Typical as-cast ingot microstructures are non-uniform, since uniform grain growth is only possible by uniform and fast heat extraction from a solidifying ingot. Lacking this fast and uniform heat extraction, the typical as-cast ingot microstructure has an equiaxed grain structure at the center of the ingot, surrounded by a columnar grain structure at the surface.

With regard to the manufacture of cobalt (Co) alloy based sputter targets, the conventional process includes the steps of vacuum induction melting ("VIM") raw materials of a medium purity (99.9%) to high purity (≥99.99%), and casting the molten alloy into copper (Cu), graphite or ceramic molds while under vacuum or under a partial pressure of inert gas, where the thickness of the as-cast ingots must be pre-set in order to yield the desired target thickness following a predetermined number of passes through the rolling mill. For some alloys which are prone to chemical segregation during solidification, long homogenization anneals of up to 72 hours are required to mitigate defects.

During the manufacturing process, hot rolling is used to refine grain size, homogenize the microstructure and eliminate porosity. The hot rolling operation often requires several reduction steps, and can last for over ten hours. For alloys with less than 18 at. % chromium (Cr) content, cold rolling is also used to increase target PTF, however workpieces often crack during cold rolling, severely affecting yield.

As detailed above, the sputter target manufacturing method tends to be both time consuming and inefficient, in terms of the ratio between material input and material output. For some alloys containing high boron (B), phosphorous (P) or refractory element content-containing alloys, such as Fe-Co-B, Ni-P and Co-Ta-Zr, the inherent brittleness of the alloy renders any metal working operation challenging even at high temperatures.

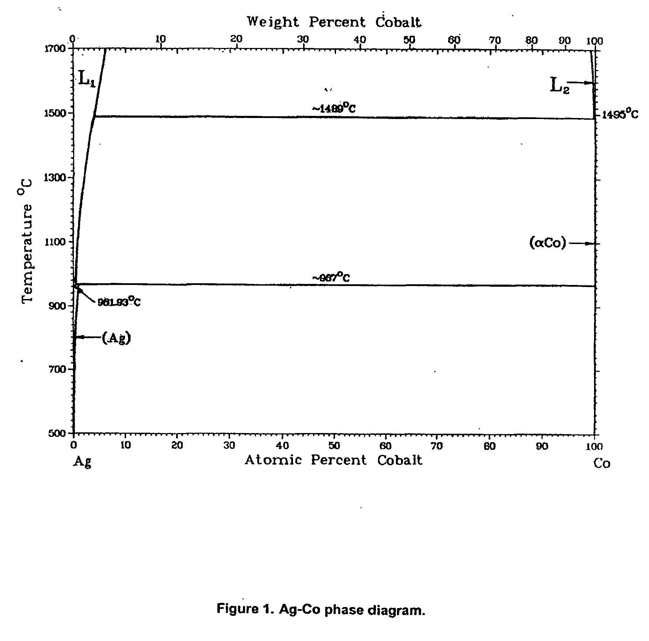

When dealing with alloys containing immiscible or insoluble constituents, conventional ingot metallurgy is not able to provide for sound ingot casting, where 'immiscibility' refers to the immixing that occurs in the liquid phase. As shown in the Figure 1 phase diagram, for example, the Ag-Co alloy system exhibits a miscibility gap delimited by the two liquidus lines L₁ and L₂ above 1489 °C, such that the liquid state solubility of silver (Ag) in cobalt (Co) is virtually nil at 1489 °C and just about 1 at. % at 1700 °C. For any molten Ag-Co alloy within this temperature range, the silver (Ag) content tends to separate and form isolated pools of pure silver (Ag) within the liquid cobalt (Co). Depending on silver (Ag) content, those pools could result in large solid particles of up to one centimeter in the as-cast structure.

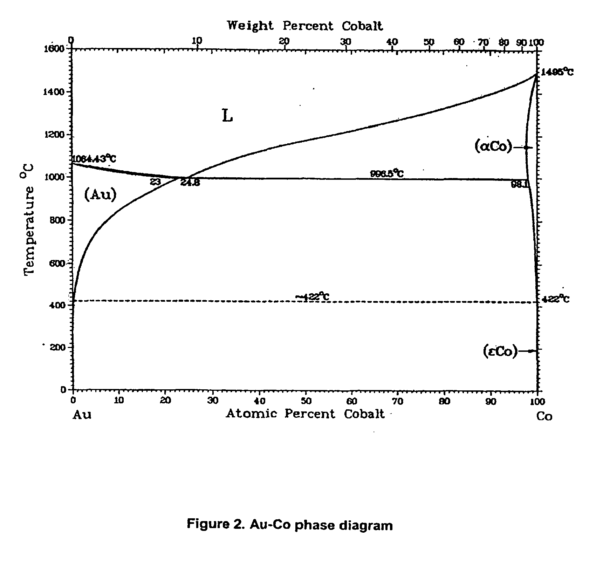

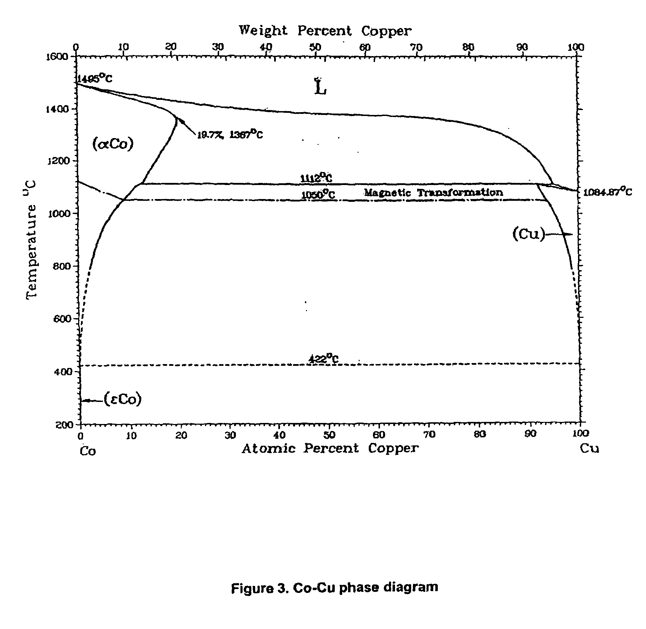

In another phase separation process, remaining liquid silver (Ag) is squeezed out of the bulk of the ingot as the solidifying cobalt (Co) skeleton shrinks, evidenced by silver (Ag) leaking to the ingot surface mentioned earlier. The Figure 2 Au-Co phase diagram and Figure 3 Co-Cu phase diagram both indicate that gold (Au) and copper (Cu) each have a very limited solid solubility in cobalt (Co). In both cases, the equilibrium phases of a cobalt (Co) rich alloy would include practically pure cobalt (εCo) and gold (Au) or cobalt (εCo) and copper (Cu) two-phase solid solutions.

Gold (Au) or copper (Cu) solid solutions typically separate as individual grains or tend to grow at the grain boundaries of the primary (εCo) phase in a cobalt (Co) alloy. Given the low melting temperature of silver (Ag)(962°C), gold (Au)(1064°C) and copper (Cu)(1085°C), their immiscibility and limited solubility in cobalt (Co) imposes another limitation with respect to the practical ingot thermo-mechanical and HIP processing temperatures.

Due to their inherent brittleness, the hot rolling operation of high boron (B) content and refractory element-containing cobalt (Co) alloys is conducted in the 1050 °C to 1100 °C temperature range to avoid cracking and other rolling failures. As such, the phase constitution of the alloys must be altered in order to avoid the incipient melting of silver (Ag), gold (Au) and copper (Cu) upon re-heating of the ingots for thermo-mechanical and HIP processing.

It is therefore desirable to provide for a sputter target manufacturing method which overcome the deficiencies of conventional manufacturing processes. In particular, it is desirable to provide for an improved sputter target manufacturing method which produces sound billet stocks for defect-free, chemically homogeneous sputter targets with enhanced PTF characteristics.

### SUMMARY OF THE INVENTION

The present invention application generally relates to sputter targets and, more particularly, relates to a solidification process and resulting sputter materials. The manufacturing approach according to the present invention produces very sound billet stocks for manufacturing defect free, chemically homogeneous sputter targets with enhanced PTF.

The manufacturing method according to the present invention includes a powder metallurgy alloy formulation, rapid solidification processing alternatives and powder consolidation and post-consolidation processing steps for the production of sputtering targets with improved properties. Processing time is significantly shortened, with no degradation of target chemical homogeneity, product bulk soundness or PTF characteristics. The manufacturing method and the resulting properties of the sputtering material apply to a broad range of low moment (chromium (Cr) content > 18 at. %) and high moment (chromium (Cr) content < 18 at. %) cobalt (Co) alloys, as well as chromium (Cr), iron (Fe), or nickel (Ni)-based alloys.

According to one arrangement, the present invention is a method of manufacturing a cobalt (Co)-based sputter target formulated as Co-(5-40 at. %)Fe-(5-20 at. %)B, or Co-(5-25 at. %)Cr-(5-25 at. %)Pt-(5-20 at. %)B-(0.2-7.5 at. %)*X₁* and optionally (0.5-7.5 at. *%*)*X₂, X₁* representing copper (Cu), silver (Ag) or gold (Au), and *X₂* representing titanium (Ti), vanadium (V), yttrium (Y), zirconium (Zr), niobium (Nb), molybdenum (Mo), ruthenium (Ru), rhenium (Rh), lanthanum (La), hafnium (Hf), tantalum (Ta), tungsten (W), or iridium (Ir). The method includes the steps of preparing a plurality of raw materials into a composition corresponding to a Co-(5-40 at. %)Fe-(5-20 at. %)B, or a Co-(5-25 at. %)Cr-(5-25 at. %)Pt-(5-20 at. %)B-(0.2-7.5 at. %)*X₁* and optionally (0.5-7.5 at. %)*X₂* alloy system, the plurality of raw materials comprising pure elements or master alloys, and heating the plurality of raw materials under vacuum or under a partial pressure of argon (Ar) to a fully liquid state to form a molten alloy corresponding to the Co-(5-40 at. %)Fe-(5-20 at. %)B, or Co-(5-25 at. %)Cr-(5-25 at. %)Pt-(5-20 at. %)B-(0.2-7.5 at. %)*X₁* and optionally (0.5-7.5 at. %)*X₂* alloy system. The method also includes the steps of solidifying the molten alloy to form an ingot, reheating the ingot to a fully liquid state to form a diffuse molten alloy, and rapidly solidifying the diffuse molten alloy into a homogeneous pre-alloyed powder material. Furthermore, the method includes the steps of consolidating the homogeneous pre-alloyed powder material into a fully dense homogeneous material, optionally hot and cold rolling the fully dense homogeneous material, and machining the fully dense homogenous material to form a sputter target.

Rapid solidification provides the means for producing reduced-scale microstructural features, since reduced grain size and finely dispersed secondary phases are desirable for enhancing the sputtering process and minimizing particle emission. At the microscopic level, the rapid solidification induced microstructure is highly chemically uniform, making the corresponding target material an excellent source for the deposition of the media film within its nominal composition.

Rapid solidification generates a non-equilibrium microstructure that can sustain most of the thermal cycling during consolidation at high temperature and thermo-mechanical processing. For gas atomization, a very high cooling rate is possible for most small powder particles of up to 350 µm average size, depending on the thermal conductivity and specific heat capacity of the alloy.

For the Co-(5-40 at. %)Fe-(5-20 at. %)B alloy system, the method further includes the step of hot rolling the fully dense homogeneous material at a temperature less than the Co-(5-40 at. %)Fe-(5-20 at. %)B alloy system solidus temperature.

The consolidating step further includes the steps of encapsulating the homogeneous pre-alloyed powder material in a can, evacuating the can at a temperature between 300 °C and 600 °C to a vacuum level between 10⁻² torr and 10⁻³ torr, sealing the can, and subjecting the can at a temperature between 300 °C and 1300 °C to a pressure between 10 kilopounds per square inch and 45 kilopounds per square inch in a pressurized hot isostatic pressing vessel

One of the plurality of raw materials is comprised of between 0.2 at. % and 2.0 at. % pure elemental silver (Ag), where the fully dense homogeneous material is hot rolled at a temperature less than 962 °C. Furthermore, one of the plurality of raw materials is comprised of pure elemental gold (Au), where the fully dense homogeneous material is hot rolled at a temperature less than 1065 °C. Moreover, one of the plurality of raw materials is comprised of pure elemental copper (Cu), where the fully dense homogeneous material is hot rolled at a temperature of less than 1085 °C.

The preparing step further includes the step of blending prescribed weight fractions of a Ag-Pt master alloy pre-alloyed powder, a Co-Cr-B and optionally *X₂* master alloy pre-alloyed powder, and elemental platinum (Pt) into the composition corresponding to the Co-(5-25 at. %)Cr-(5-25 at. %)Pt-(5-20 at. %)B-(0.2-7.5 at. %)*X₁* and optionally (0.5-7.5 at. %)*X₂* alloy system. The fully dense homogeneous material is hot rolled at a temperature of less than 1186 °C, or a temperature of less than 1030 °C.

The preparing step further includes the step of blending prescribed weight fractions of a Au-Cr master alloy pre-alloyed powder, a Co-B-Pt and optionally *X₂* master alloy pre-alloyed powder, and either an elemental chromium (Cr) or a Co-Cr master alloy pre-alloyed powder material into the composition corresponding to the Co-(5-25 at. %)Cr-(5-25 at. %)Pt-(5-20 at. %)B-(1.5-7.5 at. %)*X₁* and optionally (1.5-7.5 at. %)*X₂* alloy system. The fully dense homogeneous material is hot rolled at a temperature of less than 1160 °C, or at a temperature of less than 1070 °C.

The preparing step further includes the step of blending prescribed weight fractions of a Cu-Pt master alloy pre-alloyed powder, a Co-Cr-B and optionally *X₂* master alloy pre-alloyed powder, and elemental platinum (Pt) into the composition corresponding to the Co-(5-25 at. %)Cr-(5-25 at. %)Pt-(5-20 at. %)B-(0.2-7.5 at. %)*X₁* and optionally (0.5-7.5 at. %)*X₂* alloy system. The fully dense homogeneous material is hot rolled at a temperature of less than 1186 °C, or at a temperature of less than the solidus temperature of the Co-Cr-B master alloy.

The plurality of raw materials comprises pure elemental cobalt (Co), chromium (Cr), platinum (Pt), boron (B), *X₁* and/or *X₂,* and/or Co-Cr, Co-B, Co-Cr-B, Ag-Pt, Au-Cr, and/or Cu-Pt master alloys.

Rapid solidification of the diffuse molten alloy occurs at a rate of up to 10⁴ °C/s, or up to 10⁷ °C/s, and occurs via atomization, melt spinning, or spray forming, where the diffuse molten alloy is rapidly solidified into a homogeneous pre-alloyed powder material with an average particle size ranging between 25 µm and 350 µm. At least a first boride phase is formed in the homogeneous pre-alloyed powder material, where the first boride phase is comprised of Co₃B or a mixture of Co₃B and Co₂B borides, and where the boride size is less than 2 µm.

For the Co-(5-25 at. %)Cr-(5-25 at. %)Pt-(5-20 at. %)B-(0.2-7.5 at. *%*)*X₁* and optionally (0.5-7.5 at. %)*X₂* alloy system, a primary phase is formed in the homogeneous pre-alloyed powder material, where the primary phase is an extended solid solution comprised of Co-Cr-*X₁*-Pt or Co-Cr-*X₁-X₂*-Pt. The primary phase is an extended solid solution comprised of Co-Cr*-X₁-Pt* or Co-Cr-*X₁-X₂-*Pt containing up to 2 at. % silver (Ag), up to 7.5 at % gold (Au), or up to 7.5 at. % copper (Cu).

According to a second arrangement, the present invention is a method of manufacturing a chromium (Cr)-based sputter target formulated as Cr-(2-20 at. %)B or Cr-(2-20 at. %)C. The method includes the steps of preparing a plurality of raw materials into a composition corresponding to a Cr-(7-20 at. %)B or Cr-(5-25 at. %)C alloy system, the plurality of raw materials comprising pure elements or master alloys, and heating the plurality of raw materials under vacuum or under a partial pressure of argon (Ar) to a fully liquid state to form a molten alloy corresponding to the Cr-(7-20 at. %)B or Cr-(5-25 at. %)C alloy system. The method also includes the steps of solidifying the molten alloy to form an ingot, reheating the ingot to a fully liquid state to form a diffuse molten alloy, and rapidly solidifying the diffuse molten alloy into a homogeneous pre-alloyed powder material. The method further includes the steps of consolidating the homogeneous pre-alloyed powder material into a fully dense homogeneous material corresponding to blend composition of Cr-(2-20 at. %)B or Cr-(2-20 at. %)C, and machining the fully dense homogenous material to form a sputter target.

The method further includes the step of admixing pure elemental chromium (Cr) powder to the homogeneous pre-alloyed powder material. The homogeneous Cr-(2-20 at. %)B pre-alloyed powder material has a microstructure comprised of a supersaturated chromium (Cr) solid solution and/or a supersaturated chromium (Cr) solid solution with sub-micron Cr₂B borides, or a microstructure comprised of a supersaturated chromium (Cr) solid solution with sub-micron Cr₂₃C₆ carbides.

According to a third arrangement, the present invention is a method of manufacturing an iron (Fe)-based sputter target formulated as Fe-(5-40 at. %)Co-(5-20 at. %)B, Fe-(5-90 at. %)Ni, Fe-(5-70 at. %)Co, Fe-(30-50 at. %)Pt, or Fe-(30-55 at. %)Pd. The method includes the step of preparing a plurality of raw materials into a composition corresponding to an Fe-(5-40 at. %)Co-(5-20 at. %)B, Fe-(5-90 at. %)Ni, Fe-(5-70 at. %)Co, Fe-(30-50 at. %)Pt, or Fe-(30-55 at. %)Pd alloy system, the plurality of raw materials comprising pure elements or master alloys, and heating the plurality of raw materials under vacuum or partial pressure of argon (Ar) to a fully liquid state to form a molten alloy corresponding to the Fe-(5-40 at. %)Co-(5-20 at. %)B, Fe-(5-90 at. %)Ni, Fe-(5-70 at. %)Co, Fe-(30-50 at. %)Pt, or Fe-(30-55 at. %)Pd alloy system. The method also includes the steps of solidifying the molten alloy to form an ingot, reheating the ingot to a fully liquid state to form a diffuse molten alloy, and rapidly solidifying the diffuse molten alloy into a homogeneous pre-alloyed powder material. Furthermore, the method includes the steps of consolidating the homogeneous pre-alloyed powder material into a fully dense homogeneous material, hot rolling the fully dense homogeneous material, and machining the fully dense homogenous material to form a sputter target

For the Fe-(5-40 at. %)Co-(5-20 at. %)B alloy system, the fully dense homogeneous material is hot rolled at a temperature less then the solidus temperature. At least a first boride phase is formed in the homogeneous pre-alloyed powder material, and where the first boride phase is comprised of a metastable Fe₃B or a mixture of metastable Fe₃B and equilibrium Fe₂B borides.

According to a fourth arrangement, the present invention is a method of manufacturing a nickel (Ni)-based sputter target formulated as Ni-(10-50 at. %)P, the method including the steps of preparing a plurality of raw materials into a composition corresponding to a Ni-(10-50 at. %)P alloy system, the plurality of raw materials comprising pure elements or master alloys, and heating the plurality of raw materials under vacuum or partial pressure of argon (Ar) to a fully liquid state to form a molten alloy corresponding to the Ni-(10-50 at. %)P alloy system. The method also includes the steps of solidifying the molten alloy to form an ingot, reheating the ingot to a fully liquid state to form a diffuse molten alloy, and rapidly solidifying the diffuse molten alloy into a homogeneous pre-alloyed powder material. Furthermore, the method includes the step of consolidating the homogeneous pre-alloyed powder material into a fully dense homogeneous material, and machining the fully dense homogenous material to form a sputter target.

The homogeneous pre-alloyed powder material has a microstructure comprised of a supersaturated nickel (Ni) solid solution with less than 10 µm Ni₃P phosphides.

In the following description of the preferred embodiment, reference is made to the accompanying drawings that form a part thereof, and in which is shown by way of illustration a specific embodiment in which the invention may be practiced. It is to be understood that other embodiments may be utilized and changes may be made without departing from the scope of the present invention.

### BRIEF DESCRIPTION OF THE DRAWINGS

Referring now to the drawings, in which like reference numbers represent corresponding parts throughout:

Figure 1 is a Ag-Co phase diagram;

Figure 2 is a Au-Co phase diagram;

Figure 3 is a Co-Cu phase diagram;

Figure 4 is a flowchart depicting a method of manufacturing a cobalt (Co)-based sputter target, according to one arrangement of the present invention;

Figure 5 is a flowchart depicting the preparing step (step S402), according to one example aspect;

Figure 6 is an Ag-Pt phase diagram;

Figure 7 is an Au-Cr phase diagram;

Figure 8 is a Cu-Pt phase diagram;

Figure 9 is a flowchart depicting the consolidating step (step S408), according to one example aspect;

Figure 10 is a scanning electron microscope ("SEM") backscattered diagram of an as-cast Co-(8 at. %)Cr-(7 at. %)Pt-(8 at. %)B alloy;

Figure 11 is an SEM backscattered diagram of a rapidly solidified Co-(8 at. %)Cr-(7 at. %)Pt-(8 at %)B alloy;

Figure 12 depicts the X-ray diffraction patterns of an as-cast and rapidly solidified Co-(8 at. %)Cr-(7 at. %)Pt-(8 at. %)B alloy;

Figure 13 is a flowchart depicting a method of manufacturing a chromium (Cr)-based sputter target, according to a second arrangement of the present invention;

Figures 14A and 14B are SEM backscattered images of gas atomized Cr-(13.5 at. %)B alloy, under low magnification and high magnification, respectively;

Figure 15 is an SEM backscattered image of gas atomized Cr-(14 at. %)C alloy;

Figure 16 is a flowchart depicting a method of manufacturing an iron (Fe)-based sputter target, according to a third arrangement of the present invention;

Figure 17 is an SEM secondary electron diagram of an as-cast Fe-(30.6 at. %)Co-(12.8 at. %)B alloy;

Figure 18 is an SEM secondary electron diagram of a rapidly solidified Fe-(30.6 at. %)Co-(12.8 at. %)B alloy;

Figure 19 depicts X-ray diffraction patterns of an as-cast and rapidly solidified Fe-(30.6 at. %)Co-(12.8 at. %)B alloy;

Figure 20 is a flowchart depicting a method of manufacturing a nickel (Ni)-based sputter target, according to a fourth arrangement of the present invention; and

Figure 21 is an SEM secondary electron image of gas atomized Ni-(20 at. %)P alloy.

### DETAILED DESCRIPTION OF THE INVENTION

The present invention provides for a sputter target manufacturing method which overcome the deficiencies of conventional manufacturing methods. In particular, the present invention provides for an improved sputter target manufacturing method which produces very sound billet stocks for defect-free, chemically homogeneous sputter targets with enhanced PTF characteristics.

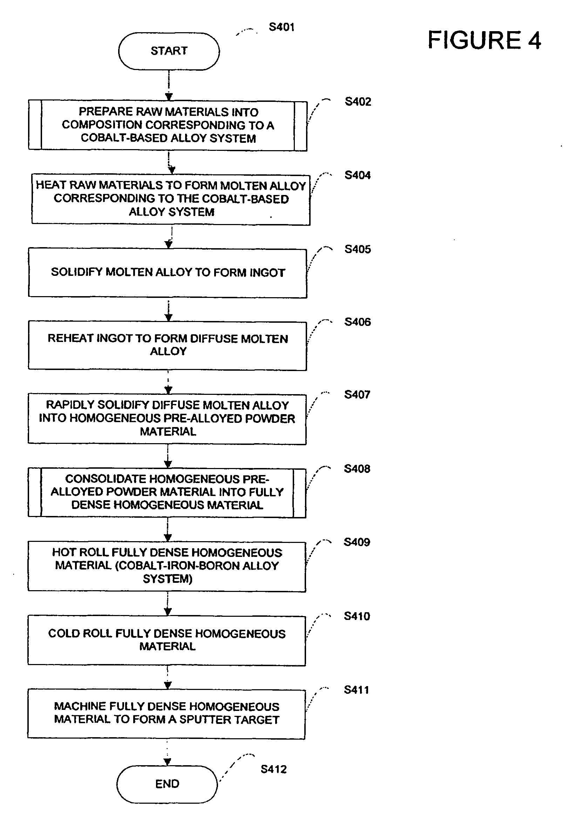

Figure 4 is a flowchart depicting a method of manufacturing a cobalt (Co)-based sputter target formulated as Co-(5-40 at. %)Fe-(5-20 at. %)B, or Co-(5-25 at. %)Cr-(5-25 at. %)Pt-(5-20 at. %)B-(0.2-7.5 at. %)*X₁* and optionally (0.5-7.5 at. %)*X₂, X₁* representing copper (Cu), silver (Ag) or gold (Au), and *X₂* representing titanium (Ti), vanadium (V), yttrium (Y), zirconium (Zr), niobium (Nb), molybdenum (Mo), ruthenium (Ru), rhenium (Rh), lanthanum (La), hafnium (Hf), tantalum (Ta), tungsten (W), or iridium (Ir) according to one arrangement of the present invention. Briefly, the method includes the steps of preparing a plurality of raw materials into a composition corresponding to a Co-(5-40 at. %)Fe-(5-20 at. %)B, or a Co-(5-25 at. %)Cr-(5-25 at. %)Pt-(5-20 at. %)B-(0.2-7.5 at. %)*X₁* and optionally (0.5-7.5 at. %)*X₂* alloy system, the plurality of raw materials comprising pure elements or master alloys, and heating the plurality of raw materials under vacuum or under a partial pressure of argon (Ar) to a fully liquid state to form a molten alloy corresponding to the Co-(5-40 at. %)Fe-(5-20 at. %)B, or Co-(5-25 at. %)Cr-(5-25 at. %)Pt-(5-20 at. %)B-(0.2-7.5 at. %)*X₁* and optionally (0.5-7.5 at. %)*X₂* alloy system. The method also includes the steps of solidifying the molten alloy to form an ingot, reheating the ingot to a fully liquid state to form a diffuse molten alloy, and rapidly solidifying the diffuse molten alloy into a homogeneous pre-alloyed powder material. Furthermore, the method includes the steps of consolidating the homogeneous pre-alloyed powder material into a fully dense homogeneous material, optionally hot and cold rolling the fully dense homogeneous material, and machining the fully dense homogenous material to form a sputter target. Accordingly, the manufacturing method is alternative alloy preparation method for the production of enhanced performance sputtering targets, which provides a solution to the problems encountered in the conventional casting practice.

In more detail, the method of manufacturing a cobalt (Co)-based sputter target formulated as Co-(5-40 at. %)Fe-(5-20 at. %)B, or Co-(5-25 at. %)Cr-(5-25 at. %)Pt-(5-20 at. %)B-(0.2-7.5 at %)*X₁* and optionally (0.5-7.5 at. %)*X₂,X₁* representing copper (Cu), silver (Ag) or gold (Au), and *X₂* representing titanium (Ti), vanadium (V), yttrium (Y), zirconium (Zr), niobium (Nb), molybdenum (Mo), ruthenium (Ru), rhenium (Rh), lanthanum (La), hafnium (Hf), tantalum (Ta), tungsten (W), or iridium (Ir), begins (step S401).

A plurality of raw materials are prepared into a composition corresponding to a Co-(5-40 at. %)Fe-(5-20 at. %)B, or a Co-(5-25 at. %)Cr-(5-25 at. %)Pt-(5-20 at. %)B-(0.2-7.5 at. %)*X₁* and optionally (0.5-7.5 at. %)*X₂* alloy system, the plurality of raw materials comprising pure elements or master alloys (step S402). For cobalt (Co)-based alloys, silver (Ag), gold (Au) or copper (Cu) are added as a signal-to-noise ratio booster. Since these elements are immiscible in cobalt (Co), using conventional methods they tend to separate from the cobalt (Co) liquid solution upon casting and form pools of pure silver (Ag), gold (Au) or copped (Cu), which later solidify into distinct clusters, or leak to the ingot surface.

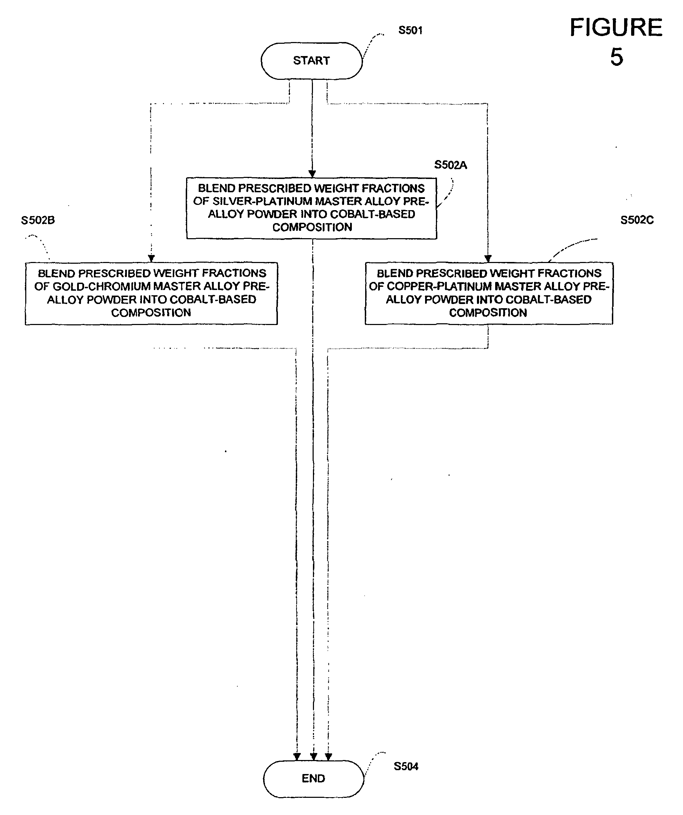

Figure 5 is a flowchart depicting the preparing step (step S402) in more detail, according to one example aspect of the first arrangement of the present invention. Generally, the preparing step (step S402) further includes the step of blending prescribed weight fractions of a master alloy pre alloyed powder and an alloying element (or elements) into a composition corresponding to the desired alloy system.

In more detail, and according to one aspect, the process begins (step S501), and prescribed weight fractions of a Ag-Pt master alloy pre-alloyed powder, a Co-Cr-B and optionally *X₂* master alloy pre-alloyed powder, and elemental platinum (Pt) are blended into the composition corresponding to the Co-(5-25 at. %)Cr-(5-25 at. %)Pt-(5-20 at. %)B-(0.2-7.5 at. %)*X₁* and optionally (0.5-7.5 at. %)*X₂* alloy system (step S502A), and the process ends (step S504). According to this aspect, the fully dense homogeneous material is hot rolled at a temperature of less than 1186 °C, or a temperature of less than 1030 °C (see step S409, *infra*), although the hot-rolling step may be optionally omitted.

According to this particular aspect, the Ag-Pt alloy is prepared using a plurality of raw materials comprised of substantially pure silver (Ag) and platinum (Pt) melt stocks, where the prescribed platinum (Pt) content is approximately 10 at. % to 90 at. %, preferably 40 at. % to 42 at. %. The plurality of raw materials are heated to a fully liquid state to form a molten alloy having substantially the same prescribed platinum (Pt) content, and the molten alloy is solidified to form an ingot. The Ag-Pt ingot is reheated to a fully liquid state and rapidly solidified into a pre-alloyed Ag-Pt pre-alloyed powder material.

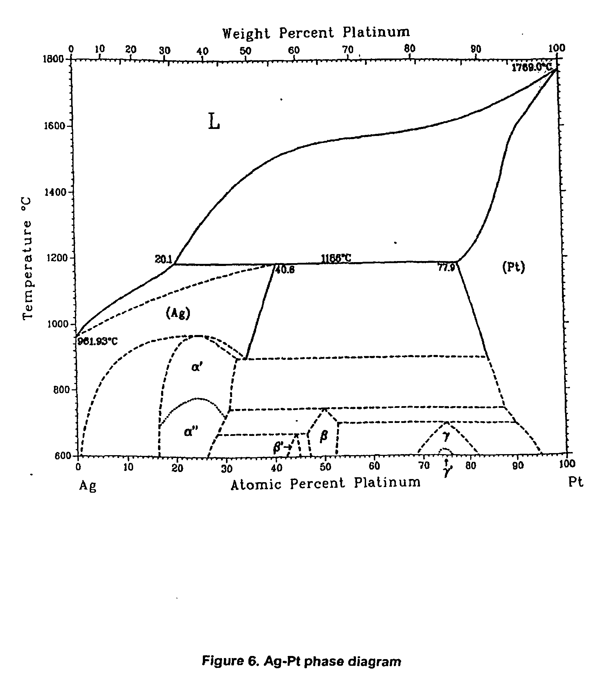

Figure 6 is a Ag-Pt phase diagram, which reveals that a peritectic reaction involving a silver (Ag)-rich liquid ("L") and a platinum (Pt) solid solution occurs at approximately 1186 °C. For an alloy containing about 40.6 at. % platinum (Pt), a silver (Ag) solid solution of the same composition is produced. Other silver (Ag) alloys containing less than 40.6 at. % will exhibit an incipient melting upon heating for which the onset point is determined by the dashed solidus line.

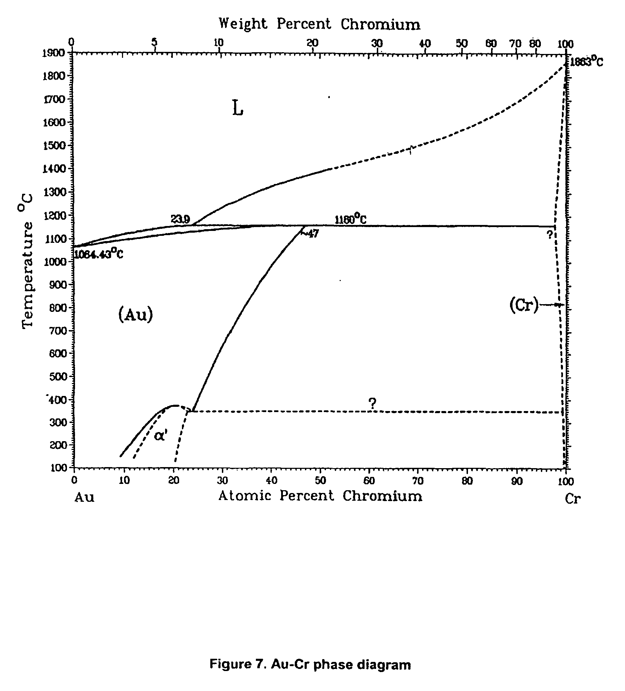

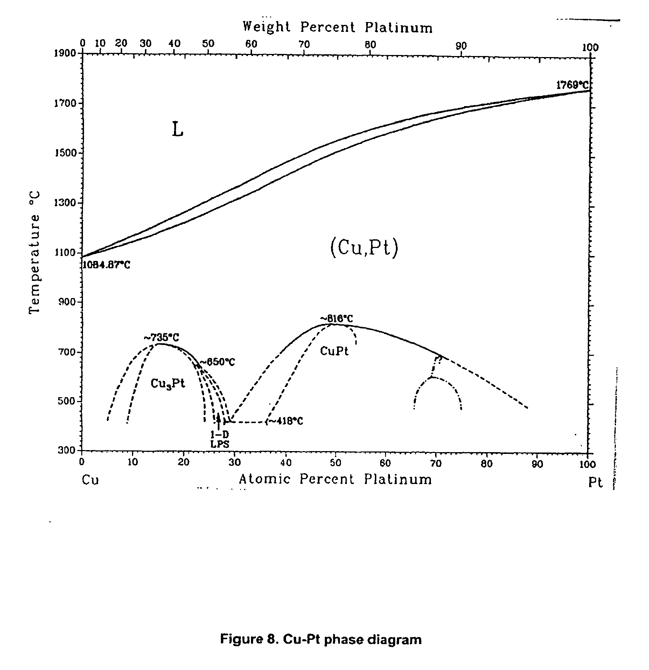

Depending on the post atomization processing temperature requirement, the starting raw materials for manufacturing a CoCrPtB*X₁* or a CoCrPtB*X₁-X₂* alloy could be split up into two pre-alloyed powders including a Ag-Pt alloy and a CoCrB(Pt) or CoCrB(Pt) *X₁* alloy, to which a platinum (Pt) powder could be added for balance. Such a formulation offers a hot processing temperature window up to 1186 °C for silver (Ag)-containing alloys and ensures an improved distribution of silver (Ag) throughout the target. A similar approach could be attempted for gold (Au) or copper (Cu) containing alloys using pre-alloyed Au-Cr or Cu-Pt powders to provide a wider processing temperature window up to 1160 °C and much higher temperatures for copper (Cu) containing alloys as shown in phases diagrams presented in Figures 7 and 8.

According to a second, alternate aspect, the process begins (step S501), and prescribed weight fractions of a Au-Cr master alloy pre-alloyed powder, a Co-B-Pt and optionally X₂ master alloy pre-alloyed powder, and either an elemental chromium (Cr) or a Co-Cr master alloy pre-alloyed powder are blended into the composition corresponding to the Co-(5-25 at. %)Cr-(5-25 at. %)Pt-(5-20 at %)B-(1.5-7.5 at. %)*X₁* and optionally (1.5-7.5 at. %)*X₂* alloy system (step S502B), and the process ends (step S504). The fully dense homogeneous material is hot rolled at a temperature of less than 1160 °C, or at a temperature of less than 1070 °C (see step S409, *infra*), although the hot-rolling step may be optionally omitted.

According to this particular aspect, the Au-Cr alloy is prepared using a plurality of raw materials comprised of substantially pure gold (Au) and chromium (Cr) melt stocks, where the prescribed chromium (Cr) content is approximately 10 at. % to 80 at. %, preferably 47 at. % to 49 at. %. The plurality of raw materials are heated to a fully liquid state to form a molten alloy having substantially the same prescribed chromium (Cr) content, and the molten alloy is solidified to form an ingot The Au-Cr ingot is reheated to a fully liquid state and rapidly solidified into a pre-alloyed Au-Cr pre-alloyed powder material.

According to a third, alternate aspect, the process begins (step S501), and prescribed weight fractions of a Cu-Pt master alloy pre-alloyed powder, a Co-Cr-B and optionally *X₂* master alloy pre-alloyed powder, and elemental platinum (Pt) are blended into the composition corresponding to the Co-(5-25 at. %)Cr-(5-25 at. %)Pt-(5-20 at. %)B-(0.2-7.5 at. %)*X₁* and optionally (0.5-7.5 at. *%*)*X₂* alloy system (step S502C), and the process ends (step S504). The fully dense homogeneous material is hot rolled at a temperature of less than 1186 °C, or at a temperature of less than the solidus temperature of the Co-Cr-B master alloy (see step S409, *infra*), although the hot-rolling step may be optionally omitted.

According to this particular aspect, the Co-Cr-B and optionally *X₂* alloy is prepared using a plurality of raw materials and/or master alloys which, for a given Cu-Pt alloy, are chosen to provide the proper atomic balance for the Co-(5-25 at. %)Cr-(5-25 at. %)Pt-(5-20 at. %)B and optionally (0.5-7.5 at. %)*X₂* alloy system. The plurality of raw materials are heated to a fully liquid state to form a molten alloy, and the molten alloy is solidified to form an ingot. The ingot is reheated to a fully liquid state and rapidly solidified into a pre-alloyed powder material.

As indicated above, the starting raw materials for manufacturing a CoCrPtB*X₁* or a CoCrPtB*X₁*-*X₂* alloy could be split up into two pre-alloyed powders including a Ag-Pt alloy and a CoCrB(Pt) or CoCrB(Pt) *X₁* alloy, to which a platinum (Pt) powder could be added for balance. A similar approach could be attempted for gold (Au) or copper (Cu) containing alloys using pre-alloyed Au-Cr or Cu-Pt powders to provide a wider processing temperature window up to 1160 °C and much higher temperatures for copper (Cu) containing alloys as shown in phases diagrams presented in Figures 7 and 8.

As a non-depicted alternative to the above formulations, one of the plurality of raw materials is comprised of between 0.2 at. % and 2.0 at. % pure elemental silver (Ag), where the fully dense homogeneous material is hot rolled (step S409, *infra*) at a temperature less than 962 °C. Alternatively, one of the plurality of raw materials is comprised of pure elemental gold (Au), where the fully dense homogeneous material is hot rolled (step S409, *infra*) at a temperature less than 1065 °C. As a further alternative, one of the plurality of raw materials is comprised of pure elemental copper (Cu), where the fully dense homogeneous material is hot rolled (step S409, *infra*) at a temperature of less than 1085 °C. Moreover, the plurality of raw materials may include pure elemental cobalt (Co), chromium (Cr), platinum (Pt), boron (B), *X₁* and/or *X₂,* and/or Co-Cr, Co-B, Co-Cr-B, Ag-Pt, Au-Cr, and/or Cu-Pt master alloys.

Returning to Figure 4, the plurality of raw materials are heated under vacuum or under a partial pressure of argon (Ar) to a fully liquid state to form a molten alloy corresponding to the Co-(5-40 at. %)Fe-(5-20 at. %)B, or Co-(5-25 at. %)Cr-(5-25 at. %)Pt-(5-20 at. %)B-(0.2-7.5 at. %)*X₁* and optionally (0.5-7.5 at. %)*X₂* alloy system (step S404). The molten alloy is solidified to form an ingot (step S405), and the ingot is reheated to a fully liquid state to form a diffuse molten alloy (step S406).

The diffuse molten alloy is rapidly solidified into a homogeneous pre-alloyed powder material (step S407). Rapid solidification provides the means for producing extremely reduced scale microstructural features, since reduced grain size and finely dispersed secondary phases are desirable for enhancing the sputtering process and minimizing particle emission. At the microscopic level, the rapid solidification induced microstructure is highly chemically uniform and the corresponding target material is an excellent source for the deposition of the media film within its nominal composition. Microstructure refinement has an important impact on reducing the brittleness of intermetallic containing alloys. Generally, brittleness is exacerbated when the size of the precipitates of the intermetallic phase is large.

Rapid solidification generates a non-equilibrium microstructure that can sustain most of the thermal cycling during consolidation at high temperature and thermo-mechanical processing. For gas atomization, a very high cooling rate is possible for most small powder particles of up to 350 µm average size, depending on the thermal conductivity and specific heat capacity of the alloy.

Rapid solidification of the diffuse molten alloy occurs at a rate of up to 10⁴ °C/s, or up to 10⁷ °C/s. Rapid solidification occurs via atomization, melt spinning, or spray forming, where the diffuse molten alloy is rapidly solidified into a homogeneous pre-alloyed powder material with an average particle size ranging between 25 µm and 350 µm.

From a thermodynamic standpoint, because of the limited heat evacuation imposed by the slow heat transfer at the mold-ingot interface, ingot solidification generally follows the equilibrium illustrated in the corresponding phase diagrams. In many cases, the as-cast alloy phase constitution limits the performance of the sputtering process, for instance where the stoichiometry of the secondary phases determines the PTF of the target, affecting the overall properties of the sputtered film.

Rapid solidification techniques are used by the present invention for the preparation of sputtering target alloys, where rapid quenching from the molten state enables the solidification of any sputtering material while achieving microstructural uniformity, fineness and integrity for further processing. Given the high cooling rate which could be achieved in rapid solidification, a non-equilibrium liquid-to-solid transformation is favored. The products of such rapid quenching include a completely amorphous solid alloy, an alloy containing metastable phases not predicted in the phase diagram and/or extended or supersaturated solid solutions.

Rapid solidification techniques, such as atomization, melt spinning and spray forming, have been utilized for various applications in the aerospace industry, and for other special applications, since atomization processes are capable of producing segregation-free pre-alloyed materials with much refined microstructures. The particle size distribution of the powder is usually determined by the atomization technique, and for a given atomization technique, by the parameters of the technique itself and alloy liquid properties. For instance, gas atomization is known to produce a finer powder than centrifugal atomization.

The homogeneous pre-alloyed powder is consolidated into a fully dense homogeneous material (step S408). At least a first boride is formed in the homogeneous pre-alloyed powder material, where the first boride phase is comprised of Co₃B or a mixture of Co₃B and Co₂B borides or other boride compositions, where the boride size is less than 2 µm. For the Co-(5-25 at. %)Cr-(5-25 at. %)Pt-(5-20 at. %)B-(0.2-7.5 at. *%*)*X₁* and optionally (0.5-7.5 at. %)*X₂* alloy system, a primary phase is formed in the homogeneous pre-alloyed powder material, where the primary phase is an extended solid solution comprised of Co-Cr-*X₁*-Pt or Co-Cr-*X₁*-*X₂*-Pt containing up to 2 at. % silver (Ag) or up to 7.5 at % gold (Au), or up to 7.5 at. % copper (Cu), or another composition.

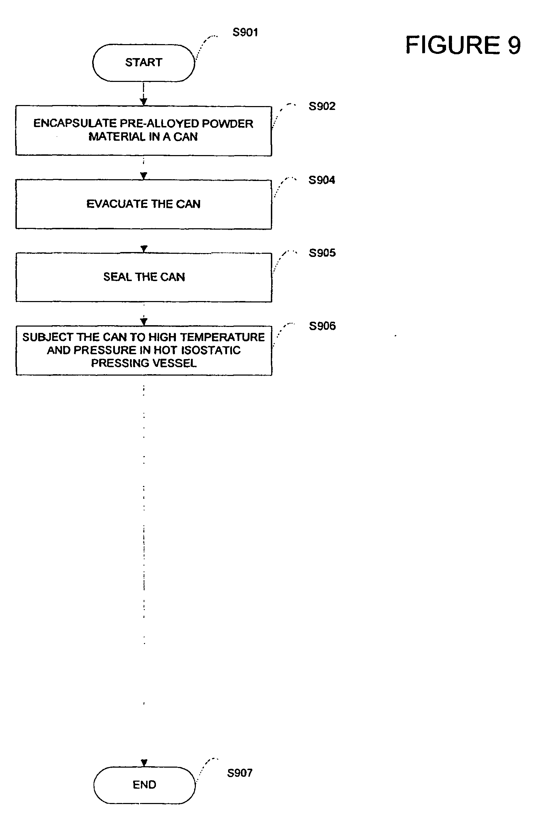

Figure 9 is a flowchart depicting the consolidating step (step S408), according to one example aspect of the present arrangement, although other consolidation processes may be used as well. In detail, the consolidating step (step S408) begins (step S901), and the homogeneous pre-alloyed powder material is encapsulated in a can (step S902). The can is evacuated at a temperature between 300 °C and 600 °C to a vacuum level between 10⁻² torr and 10⁻³ torr (step S904), and the can is sealed (step S905). The can is subjected at a temperature between 300 °C and 1300 °C to a pressure between 10 kilopounds per square inch and 45 kilopounds per square inch in a pressurized hot isostatic pressing vessel (step S906), and the process ends (step S907).

Returning to Figure 4, for the Co-(5-40 at. %)Fe-(5-20 at. %)B alloy system, the method further includes the step of hot rolling the fully dense homogeneous material at a temperature less than the Co-(5-40 at. %)Fe-(5-20 at. %)B alloy system solidus temperature (step S409), although the hot rolling step can be omitted if desired. The fully dense homogeneous material is cold rolled (step S410), and machined to form a sputter target (step S411), and the method ends (step S412).

For gas atomization, helium (He) is used because of its lower viscosity and higher sonic velocity, producing a much finer powder than argon (Ar). By increasing the disc rotations-per-minute ("RPM") or electrode RPM in the centrifugal or rotating electrode atomization processes, the average particle size is reduced. In many atomization cases, higher liquid alloy viscosity and/or surface tension results in larger particles. In rapid solidification, the rate of cooling is inversely proportional to the particle size. While complete amorphization of the solid alloy is not easily achievable for the final target product, rapid solidification generates a non-equilibrium microstructure that can sustain most of the thermal cycling during consolidation at high temperature and thermo-mechanical processing.

Under the rapid solidification approach, an extended solid solubility of up to 18 at. % gold (Au) is achieved, as found in some splat cooled Co-Au alloys, and an extended solid solution of copper (Cu) in cobalt (Co) containing up to 15 at. % copper (Cu) in quenched Co-Cu liquid alloys. For silver (Ag) containing cobalt (Co) alloys, it is possible to retain few silver (Ag) atoms in a cobalt (Co) solid solution, however, for high silver (Ag) content (2 at. % and up) alloys, due to the presence of a liquid miscibility gap, silver (Ag) will likely solidify into distinct particles upon atomization. Therefore, it is preferable to introduce silver (Ag) through a master alloy that is fully miscible and/or forms an intermediate phase with silver (Ag).

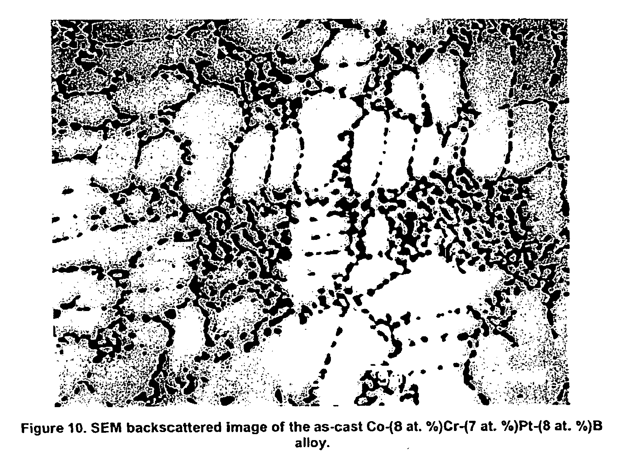

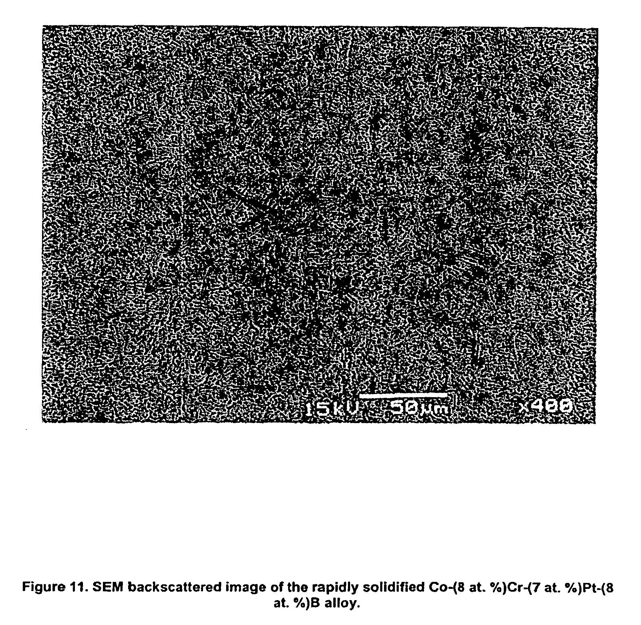

SEM and microprobe analysis has shown that the typical as-cast microstructure of a CoCrPtB alloy is constituted of primary boron (B) free dendritic CoPtCr phase surrounded by an aggregate of smaller lamellae of a eutectic phase including the primary CoPtCr phase and a Co₂B boride. A representative microstructure of an as-cast Co-(8 at. %)Cr-(7 at. %)Pt-(8 at. %)B alloy is shown in Figure 10. By comparison, as illustrated in Figure 11, rapid solidification of the cobalt (Co)-based alloy results in the development of very fine microstructures, where the cobalt (Co) boride phase size is significantly reduced. The distribution of the boride phase is also very uniform as compared to the distribution of the boride phase in the as-cast microstructure.

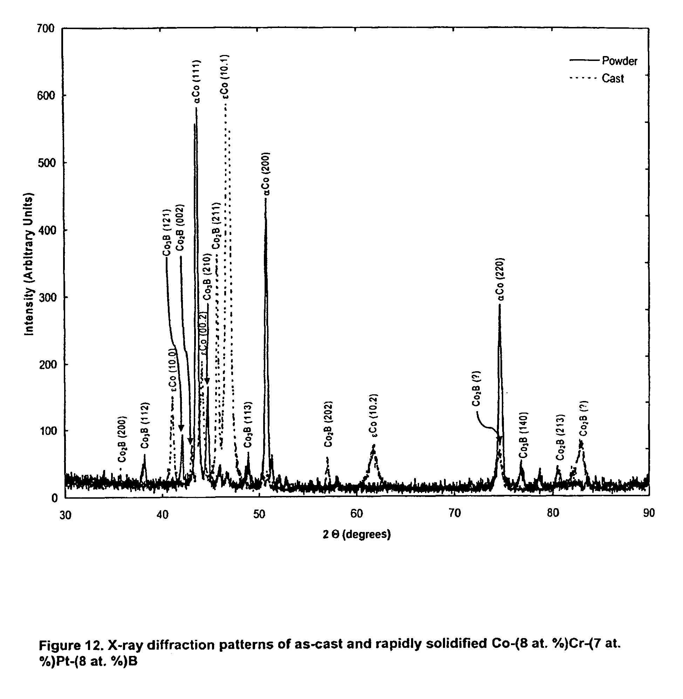

The phase constitution of the as-cast and rapidly solidified Co-(8 at. %)Cr-(7 at. %)Pt-(8 at. %)B alloy has been determined by X-ray diffraction, where the results of the analysis are summarized in the diffraction patterns shown in Figure 12. In the as-cast alloys, the equilibrium borides Co₂B and Fe₂B were formed along with the corresponding matrixes, however the rapidly solidified alloys developed a metastable Co₃B borides. This non-equilibrium boride has been shown to exhibit a fairly good thermal stability, and was not transformed even after exposure to high temperature of 1250 °C during hot consolidation.

In terms of the resulting PTF gain and uniformity and the overall distribution of the boride phase, the stoichiometry of Co₃B is much more desirable. Based on the alloy composition, the cobalt (Co) atom fraction that is retained for the formation of the boride phases in the as cast alloys is 0.16, compared to the corresponding atom fraction for the rapidly solidified alloys which is 0.24. Accordingly, the volume fractions of matrix phases in the cobalt (Co) alloy which constitutes the ferromagnetic phases is substantially reduced for the rapidly solidified alloy, when compared to the as-cast alloy. The reduction of the matrix volume fraction and the increase of the volume fraction of the boride phase are important contributors to PTF gain and uniformity. Furthermore, the increased volume fraction of the boride phase in the rapidly solidified material is highly desirable for achieving a uniform distribution of boron (B). In the as-cast alloy, the second equilibrium Co₂B boride was formed along with the corresponding matrix, however the rapidly solidified alloy developed the first equilibrium Co₃B boride.

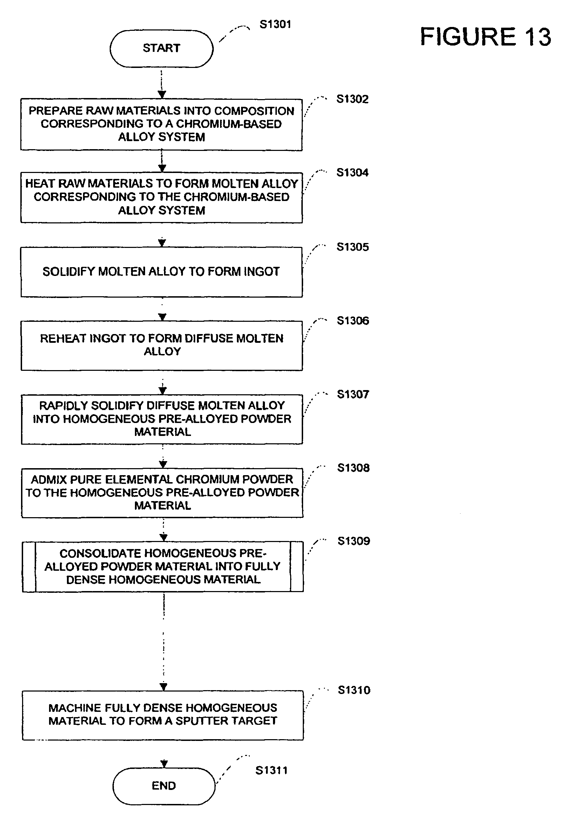

Figure 13 is a flowchart depicting a method of manufacturing a chromium (Cr)-based sputter target formulated as Cr-(2-20 at. %)B or Cr-(2-20 at. %)C, according to a second arrangement of the present invention. Briefly, the method includes the steps of preparing a plurality of raw materials into a composition corresponding to a Cr-(7-20 at. %)B or Cr-(5-25 at. %)C alloy system, the plurality of raw materials comprising pure elements or master alloys, and heating the plurality of raw materials under vacuum or under a partial pressure of argon (Ar) to a fully liquid state to form a molten alloy corresponding to the Cr-(7-20 at. %)B or Cr-(5-25 at. %)C alloy system. The method also includes the steps of solidifying the molten alloy to form an ingot, reheating the ingot to a fully liquid state to form a diffuse molten alloy, and rapidly solidifying the diffuse molten alloy into a homogeneous pre-alloyed powder material. The method further includes the steps of consolidating the homogeneous pre-alloyed powder material into a fully dense homogeneous material corresponding to blend composition of Cr-(2-20 at. %)B or Cr-(2-20 at. %)C, and machining the fully dense homogenous material to form a sputter target.

In more detail, the method of manufacturing a chromium (Cr)-based sputter target formulated as Cr-(2-20 at. %)B or Cr-(2-20 at. %)C begins (step S1301), and a plurality of raw materials are prepared into a composition corresponding to a Cr-(7-20 at. %)B or Cr-(5-25 at. %)C alloy system, the plurality of raw materials comprising pure elements or master alloys (step S1302).

The plurality of raw materials are heated under vacuum or under a partial pressure of argon (Ar) to a fully liquid state to form a molten alloy corresponding to the Cr-(7-20 at. %)B or Cr-(5-25 at. %)C alloy system (step S1304). The molten alloy is solidified to form an ingot (step S1305), and the ingot is reheated to a fully liquid state to form a diffuse molten alloy (step S1306). The diffuse molten alloy is rapidly solidified into a homogeneous pre-alloyed powder material (step S1307).

Pure elemental chromium (Cr) powder is admixed to the homogeneous pre-alloyed powder material (step S1308). The homogeneous Cr-(2-20 at. %)B pre-alloyed powder material has a microstructure comprised of a solution or solid solution, such as a supersaturated chromium (Cr) solid solution and/or a supersaturated chromium (Cr) solid solution with sub-micron Cr₂B borides or other boride, or a microstructure comprised of a supersaturated chromium (Cr) solid solution with sub-micron Cr₂₃C₆ carbides or other carbide. In an alternate aspect, the admixing step (step 1308) is omitted.

The homogeneous pre-alloyed powder is consolidated into a fully dense homogeneous material corresponding to blend composition of Cr-(2-20 at. %)B or Cr-(2-20 at. %)C (step S1309). The consolidating step (step S1309) occurs by encapsulating the homogeneous pre-alloyed powder material is encapsulated in a can, and evacuated the can at a temperature between 300 °C and 600 °C to a vacuum level between 10⁻² torr and 10⁻³ torr, and the can is sealed. The can is subjected at a temperature between 300 °C and 1300 °C to a pressure between 10 kilopounds per square inch and 45 lcilopounds per square inch in a pressurized hot isostatic pressing vessel. The consolidating step (step S1309) could occur using other methods as well.

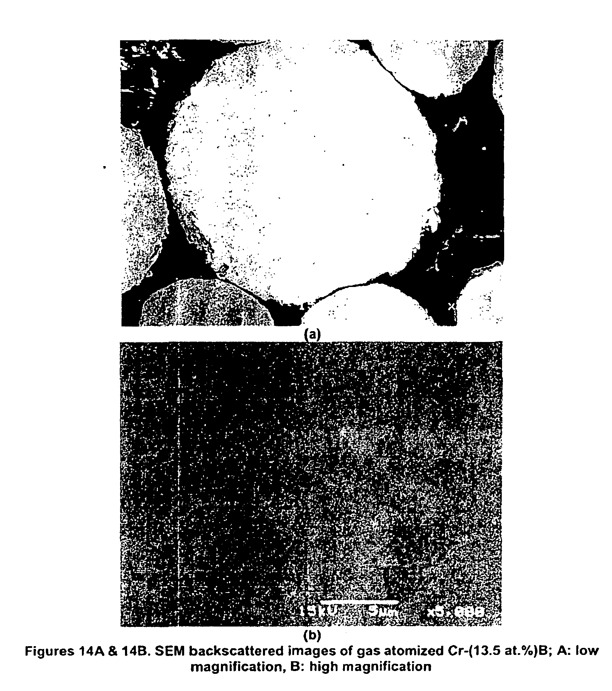

The fully dense homogenous material is machined to form a sputter target (step S1310), and the process ends (step S1311). As-cast Cr-(13.5 at. %)B exhibits a coarse eutectic microstructure including Cr and Cr₂B alternating lamellae. Coarse chromium (Cr) borides are known to cause severe particle generation during sputtering, and the formation of these borides should be avoided, unless the size of the borides is reduced. Figures 14A and 14B depict the microstructure of a gas atomized Cr-(13.5 at. %)B, in which a fully extended solid solution with no formed boride phase is exhibited.

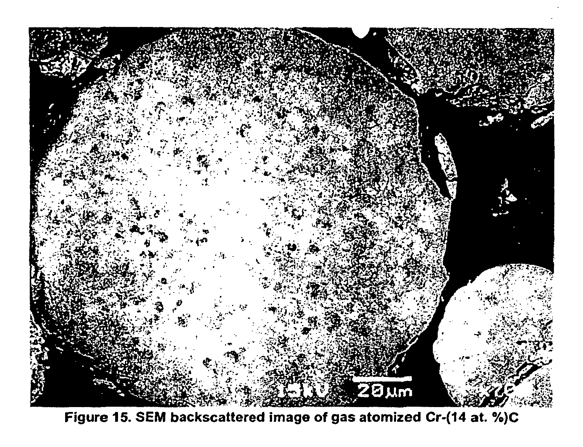

Cr-C as-cast alloys tend to form coarse carbides which cause a poor machining finish and generate particle defects during sputtering. Figure 15, for example, depicts the internal microstructure of gas atomized Cr-(14 at. %)C, in which rapid solidification resulted in the reduction of the chromium (Cr) carbides particle size to about 5 µm.

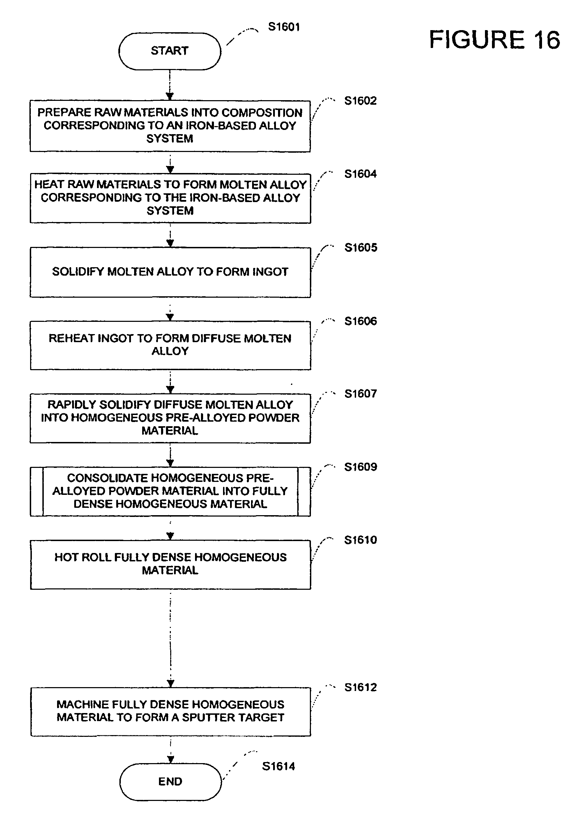

Figure 16 is a flowchart depicting a method of manufacturing an iron (Fe)-based sputter target formulated as Fe-(5-40 at. %)Co-(5-20 at. %)B, Fe-(5-90 at. %)Ni, Fe-(5-70 at. %)Co, Fe-(30-50 at. %)Pt, or Fe-(30-55 at. %)Pd, according to a third arrangement of the present invention. Briefly, the method includes the step of preparing a plurality of raw materials into a composition corresponding to an Fe-(5-40 at. %)Co-(5-20 at. %)B, Fe-(5-90 at. %)Ni, Fe-(5-70 at. %)Co, Fe-(30-50 at. %)Pt, or Fe-(30-55 at. %)Pd alloy system, the plurality of raw materials comprising pure elements or master alloys, and heating the plurality of raw materials under vacuum or partial pressure of argon (Ar) to a fully liquid state to form a molten alloy corresponding to the Fe-(5-40 at. %)Co-(5-20 at. %)B, Fe-(5-90 at. %)Ni, Fe-(5-70 at. %)Co, Fe-(30-50 at. %)Pt, or Fe-(30-55 at. %)Pd alloy system. The method also includes the steps of solidifying the molten alloy to form an ingot, reheating the ingot to a fully liquid state to form a diffuse molten alloy, and rapidly solidifying the diffuse molten alloy into a homogeneous pre-alloyed powder material. Furthermore, the method includes the steps of consolidating the homogeneous pre-alloyed powder material into a fully dense homogeneous material, hot rolling the fully dense homogeneous material, and machining the fully dense homogenous material to form a sputter target.

In more detail, the method of manufacturing an iron (Fe)-based sputter target formulated as Fe-(5-40 at. %)Co-(5-20 at. %)B, Fe-(5-90 at. %)Ni, Fe-(5-70 at. %)Co, Fe-(30-50 at. %)Pt, or Fe-(30-55 at. %)Pd begins (step S1601), and a plurality of raw materials is prepared into a composition corresponding to an Fe-(5-40 at. %)Co-(5-20 at. %)B, Fe-(5-90 at. %)Ni, Fe-(5-70 at. %)Co, Fe-(30-50 at. %)Pt, or Fe-(30-55 at. %)Pd alloy system, the plurality of raw materials comprising pure elements or master alloys (step S1602).

The plurality of raw materials is heated under vacuum or partial pressure of argon (Ar) to a fully liquid state to form a molten alloy corresponding to the Fe-(5-40 at. %)Co-(5-20 at. %)B, Fe-(5-90 at. %)Ni, Fe-(5-70 at. %)Co, Fe-(30-50 at. %)Pt, or Fe-(30-55 at. %)Pd alloy system (step S1604). The molten alloy is solidified to form an ingot (step S1605), and the ingot is reheated to a fully liquid state to form a diffuse molten alloy (step S1606).

The diffuse molten alloy is rapidly solidified into a homogeneous pre-alloyed powder material (step S1607). At least a first boride phase is formed in the homogeneous pre-alloyed powder material, where the first boride phase is comprised of a metastable Fe₃B or a mixture of metastable Fe₃B and equilibrium Fe₂B borides, or other boride compositions.

The homogeneous pre-alloyed powder is consolidated into a fully dense homogeneous material (step S1609). The consolidating step (step S1609) occurs by encapsulating the homogeneous pre-alloyed powder material is encapsulated in a can, and evacuated the can at a temperature between 300 °C and 600 °C to a vacuum level between 10⁻² torr and 10⁻³ torr, and the can is sealed. The can is subjected at a temperature between 300 °C and 1300 °C to a pressure between 10 kilopounds per square inch and 45 kilopounds per square inch in a pressurized hot isostatic pressing vessel. The consolidating step (step S1609) could occur using other methods as well.

The fully dense homogeneous material is hot-rolled (step S1610). For the Fe-(5-40 at. %)Co-(5-20 at. %)B alloy system, the fully dense homogeneous material is hot rolled at a temperature less then the solidus temperature. The fully dense homogenous material is machined to form a sputter target (step S1612), and the method ends (step S1614).

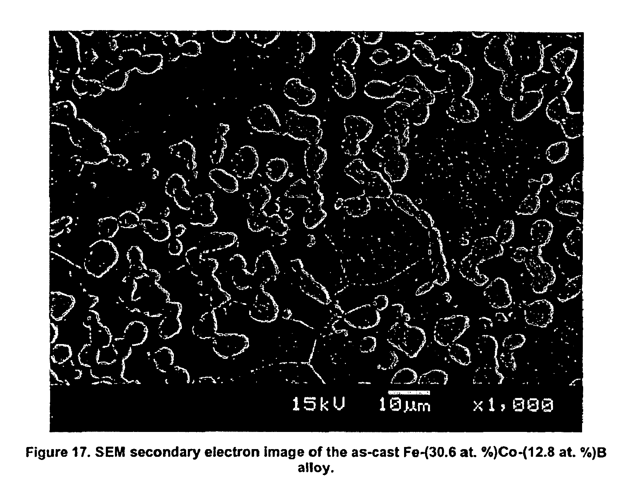

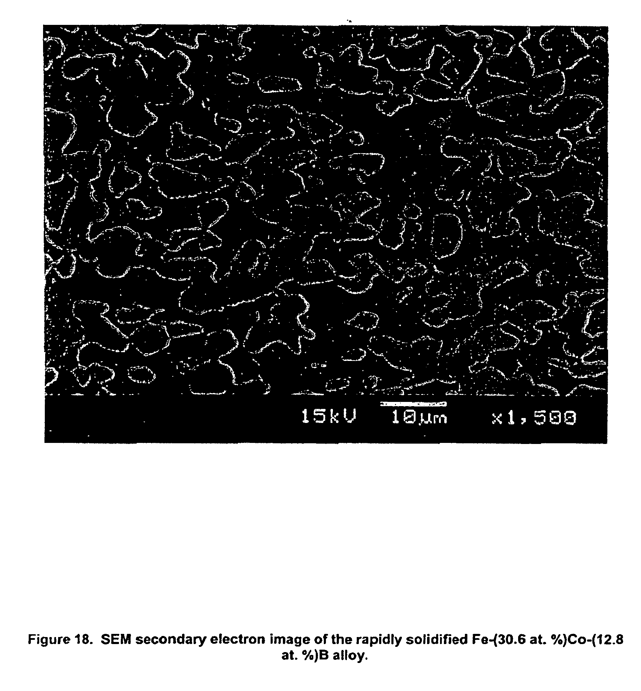

As illustrated in Figure 17, the microstructure of as-cast Fe-(30.6 at. %)Co-(12.8 at. %)B includes an α' ordered structure matrix and the Fe₂B boride. By comparison, as illustrated in Figure 18, rapid solidification of the iron (Fe)-based alloy results in the development of very fine microstructures, where the Fe boride phase sizes are significantly reduced. The distribution of those boride phases is also very uniform as compared to the distributions of the borides in the as-cast microstructure.

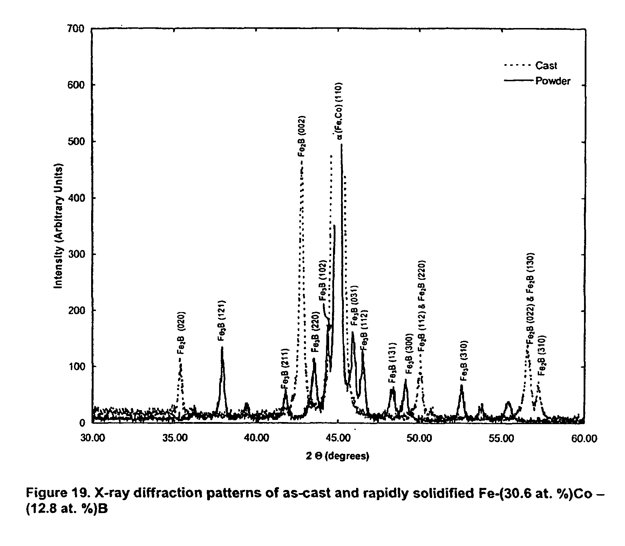

Figure 19 depicts the results of an X-ray diffraction analysis of the phase constitution of the as-cast and rapidly solidified Fe-(30.6 at. %)Co-(12.8 at. %)B alloy. In the as-cast alloy, the equilibrium Fe₂B boride was formed along with the corresponding matrix. Conversely, the rapidly solidified alloy developed the metastable Fe₃B boride, where the non-equilibrium boride exhibit a fairly good thermal stability which was not transformed even after exposure to high temperature at 1100 °C during hot consolidation.

In terms of the resulting PTF gain and uniformity and the overall distribution of the boride phase, it is clear that the stoichiometry of Fe₃B is highly desirable. Based on the alloy composition, the iron (Fe) atom fractions that are retained for the formation of the boride phases in the as-cast alloys is 0.256, while the corresponding atom fractions for the rapidly solidified alloys is 0.384. Thus, the volume fractions of matrix phase in the iron (Fe) alloy which constitutes the ferromagnetic phases is substantially reduced for the rapidly solidified alloys as compared to the as-cast alloys. The reduction of the matrix volume fraction and the increase of the volume fraction of the boride phase are important contributors to PTF gain and uniformity. Furthermore, the increased volume fraction of the boride phase in the rapidly solidified material is highly desirable for achieving a uniform distribution of boron (B).

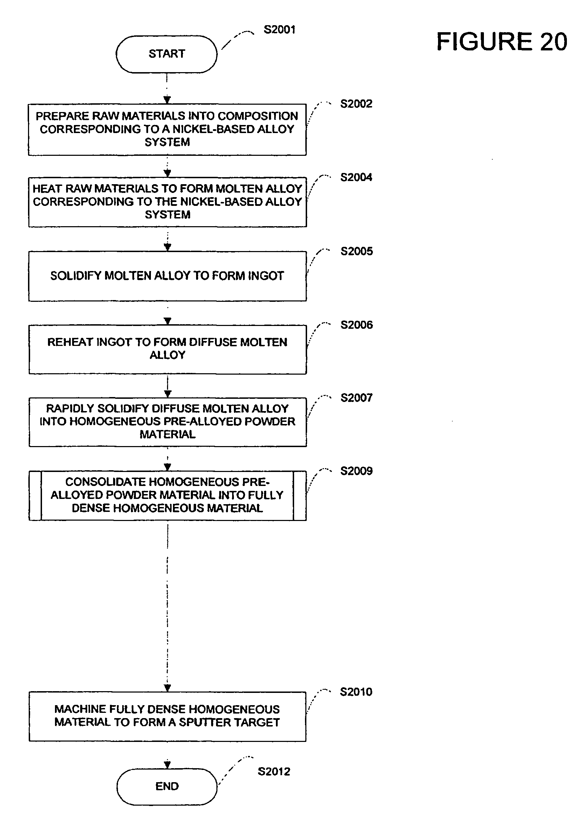

Figure 20 depicts a method of manufacturing a nickel (Ni)-based sputter target formulated as Ni-(10-50 at. %)P, according to a fourth arrangement of the present invention. Briefly, the method includes the steps of preparing a plurality of raw materials into a composition corresponding to a Ni-(10-50 at. %)P alloy system, the plurality of raw materials comprising pure elements or master alloys, and heating the plurality of raw materials under vacuum or partial pressure of argon (Ar) to a fully liquid state to form a molten alloy corresponding to the Ni-(10-50 at. %)P alloy system. The method also includes the steps of solidifying the molten alloy to form an ingot, reheating the ingot to a fully liquid state to form a diffuse molten alloy, and rapidly solidifying the diffuse molten alloy into a homogeneous pre-alloyed powder material. Furthermore, the method includes the step of consolidating the homogeneous pre-alloyed powder material into a fully dense homogeneous material, and machining the fully dense homogenous material to form a sputter target.

In more detail, the method of manufacturing a nickel (Ni)-based sputter target formulated as Ni-(10-50 at. %)P begins (step S2001), and a plurality of raw materials are prepared into a composition corresponding to a Ni-(10-50 at. %)P alloy system, the plurality of raw materials comprising pure elements or master alloys (step S2002).

The plurality of raw materials are heated under vacuum or partial pressure of argon (Ar) to a fully liquid state to form a molten alloy corresponding to the Ni-(10-50 at. %)P alloy system (step S2004). The molten alloy is solidified to form an ingot (step S2005), and the ingot is reheated to a fully liquid state to form a diffuse molten alloy (step S2006).

The diffuse molten alloy is rapidly solidified into a homogeneous pre-alloyed powder material (step S2007). The homogeneous pre-alloyed powder material has a microstructure comprised of a supersaturated nickel (Ni) solid solution with less than 10 µm Ni₃P phosphides, although other phosphides may be formed as well.

The homogeneous pre-alloyed powder is consolidated into a fully dense homogeneous material (step S2009). The consolidating step (step S2009) occurs by encapsulating the homogeneous pre-alloyed powder material is encapsulated in a can, and evacuated the can at a temperature between 300 °C and 600 °C to a vacuum level between 10⁻² torr and 10⁻³ torr, and the can is sealed. The can is subjected at a temperature between 300 °C and 1300 °C to a pressure between 10 kilopounds per square inch and 45 kilopounds per square inch in a pressurized hot isostatic pressing vessel. The consolidating step (step S2009) could occur using other methods as well.

The fully dense homogenous material is machined to form a sputter target (step S2010), and the method ends (step 52012).

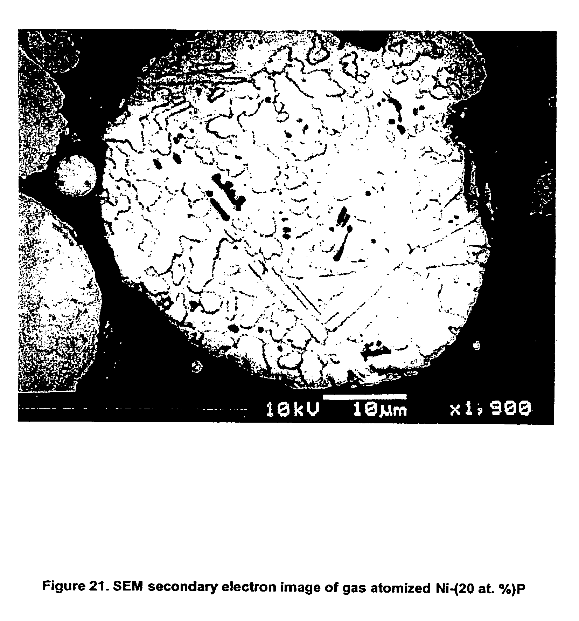

Ni-P alloys are extremely brittle due the formation of various nickel (Ni) phosphides. The size of the phosphide second phase is a determining factor for the control of the brittleness. As-cast alloys containing more than 10 at. % P are generally very brittle and have a high tendency to cracking at any loading during machining. Figure 21 reveals the internal microstruchue of gas atomized Ni-(20 at. %)P, illustrating that rapid solidification allows for the reduction of the nickel (Ni) phosphide intermetallic phase size to about 10 µm.

Rapid solidification provides the means for producing extremely reduced scale microstructural features. Reduced grain size and finely dispersed secondary phases are desirable for enhancing the sputtering process and minimizing particle emission. Furthermore, at the microscopic level, the rapid solidification induced microstructure is highly chemically uniform and the corresponding target material is an excellent source for the deposition of the media film within its nominal composition. Microstructure refinement has an important impact on reducing the brittleness of intermetallic containing alloys. Generally, brittleness is exacerbated when the size of the precipitates of the intermetallic phase is large.

Finally, the non-equilibrium nature of the liquid-to-solid transformation in rapid solidification offers the potential of forming stoichiometrically favorable secondary phases in terms of the impact on the distribution of those phases and the intrinsic properties of the target such as PTF gain and uniformity.

The manufacturing method, including the casting route, mold design and mold material selection according to the present invention provides a practical and quick fabrication procedure for the production of sputtering targets with improved properties. Processing time is significantly shortened at no sacrifice of important properties such as target chemical homogeneity, product bulk soundness and PTF.

The invention has been described with particular illustrative embodiments. It is to be understood that the invention is not limited to the above-described embodiments and that various changes and modifications may be made by those of ordinary skill in the art without departing from the spirit and scope of the invention.

## Claims

1. A method of manufacturing a cobalt (Co)-based sputter target formulated as Co-(5-40 at. %)Fe-(5-20 at. %)B, or Co-(5-25 at. %)Cr-(5-25 at. %)Pt-(5-20 at. %)B-(0.2-7.5 at. %)*X₁* and optionally (0.5-7.5 at. *%)X₂, X₁* representing copper (Cu), silver (Ag) or gold (Au), and *X₂* representing titanium (Ti), vanadium (V), yttrium (Y), zirconium (Zr), niobium (Nb), molybdenum (Mo), ruthenium (Ru), rhenium (Rh), lanthanum (La), hafnium (Hf), tantalum (Ta), tungsten (W), or iridium (Ir), the method comprising the steps of:
preparing a plurality of raw materials into a composition corresponding to a Co-(5-40 at. %)Fe-(5-20 at. %)B, or a Co-(5-25 at. %)Cr-(5-25 at. %)Pt-(5-20 at. %)B-(0.2-7.5 at. %)*X₁* and optionally (0.5-7.5 at. %)*X₂* alloy system, the plurality of raw materials comprising pure elements or master alloys;
heating the plurality of raw materials under vacuum or under a partial pressure of argon (Ar) to a fully liquid state to form a molten alloy corresponding to the Co-(5-40 at. %)Fe-(5-20 at. %)B, or Co-(5-25 at. %)Cr-(5-25 at. %)Pt-(S-20 at. %)B-(0.2-7.5 at. %)*X₁* and optionally (0.5-7.5 at. %)*X₂* alloy system;
solidifying the molten alloy to form an ingot;
reheating the ingot to a fully liquid state to form a diffuse molten alloy;
rapidly solidifying the diffuse molten alloy into a homogeneous pre-alloyed powder material;
consolidating the homogeneous pre-alloyed powder material into a fully dense homogeneous material;
cold rolling the fully dense homogeneous material; and
machining the fully dense homogenous material to form a sputter target.

2. The method according to Claim 1, wherein for the Co-(5-40 at. %)Fe-(5-20 at. %)B alloy system, the method further comprises the step of hot rolling the fully dense homogeneous material at a temperature less than the Co-(5-40 at %)Fe-(5-20 at. %)B alloy system solidus temperature.

3. The method according to Claim 1, wherein the consolidating step further comprises the steps of:
encapsulating the homogeneous pre-alloyed powder material in a can;
evacuating the can at a temperature between 300 °C and 600 °C to a vacuum level between 10⁻² torr and 10⁻³ torr;
sealing the can; and
subjecting the can at a temperature between 300 °C and 1300 °C to a pressure between 10 kilopounds per square inch and 45 kilopounds per square inch in a pressurized hot isostatic pressing vessel.

4. The method according to Claim 1, wherein one of the plurality of raw materials is comprised of pure elemental silver (Ag).

5. The method according to Claim 4, wherein one of the plurality of raw materials is comprised of between 0.2 at. % and 2.0 at. % pure elemental silver (Ag).

6. The method according to Claim 2, wherein the fully dense homogeneous material is hot rolled at a temperature less than 962 °C.

7. The method according to Claim 1, wherein one of the plurality of raw materials is comprised of pure elemental gold (Au).

8. The method according to Claim 2, wherein the fully dense homogeneous material is hot rolled at a temperature less than 1065 °C.

9. The method according to Claim 1, wherein one of the plurality of raw materials is comprised of pure elemental copper (Cu).

10. The method according to Claim 2, wherein the fully dense homogeneous material is hot rolled at a temperature of less than 1085 °C.

11. The method according to Claim 1, wherein the preparing step further comprises the step of blending prescribed weight fractions of a Ag-Pt master alloy pre-alloyed powder, a Co-Cr-B and optionally *X₂* master alloy pre-alloyed powder, and elemental platinum (Pt) into the composition corresponding to the Co-(5-25 at. %)Cr-(5-25 at. %)Pt-(5-20 at. %)B-(0.2-7.5 at. *%*)*X₁* and optionally (0.5-7.5 at. *%*)*X₂* alloy system.

12. The method according to Claim 2, wherein the fully dense homogeneous material is hot rolled at a temperature of less than 1186 °C.

13. The method according to Claim 2, wherein the fully dense homogeneous material is hot rolled at a temperature of less than 1030 °C.

14. The method according to Claim 1, wherein the preparing step further comprises the step of blending prescribed weight fractions of a Au-Cr master alloy pre-alloyed powder, a Co-B-Pt and optionally *X₂* master alloy pre-alloyed powder, and either an elemental chromium (Cr) or a Co-Cr master alloy pre-alloyed powder material into the composition corresponding to the Co-(5-25 at. %)Cr-(5-25 at. %)Pt-(5-20 at. %)B-(1.5-7.5 at. %)*X₁* and optionally (1.5-7.5 at. %)*X₂* alloy system.

15. The method according to Claim 2, wherein the fully dense homogeneous material is hot rolled at a temperature of less than 1160 °C.

16. The method according to Claim 2, wherein the fully dense homogeneous material is hot rolled at a temperature of less than 1070 °C.

17. The method according to Claim 1, wherein the preparing step further comprises the step of blending prescribed weight fractions of a Cu-Pt master alloy pre-alloyed powder, a Co-Cr-B and optionally *X₂* master alloy pre-alloyed powder, and elemental platinum (Pt) into the composition corresponding to the Co-(5-25 at. %)Cr-(5-25 at. %)Pt-(5-20 at. %)B-(0.2-7.5 at. %)*X₁* and optionally (0.5-7.5 at. *%*)*X₂* alloy system.

18. The method according to Claim 2, wherein the fully dense homogeneous material is hot rolled at a temperature of less than 1186 °C.

19. The method according to Claim 2, wherein the fully dense homogeneous material is hot rolled at a temperature of less than the solidus temperature of the Co-Cr-B master alloy.

20. The method according to Claim 1, wherein the plurality of raw materials comprises pure elemental cobalt (Co), chromium (Cr), platinum (Pt), boron (B), *X₁* and/or *X₂,* and/or Co-Cr, Co-B, Co-Cr-B, Ag-Pt, Au-Cr, and/or Cu-Pt master alloys.

21. The method according to Claim 1, where rapid solidification of the diffuse molten alloy occurs at a rate of up to 10⁴ °C/s.

22. The method according to Claim 1, where rapid solidification of the diffuse molten alloy occurs at a rate of up to 10⁷ °C/s.

23. The method according to Claim 1, wherein rapid solidification occurs via atomization.

24. The method according to Claim 23, wherein the diffuse molten alloy is rapidly solidified into a homogeneous pre-alloyed powder material with an average particle size ranging between 25 µm and 350 µm.

25. The method according to Claim 1, wherein rapid solidification occurs via melt spinning.

26. The method according to Claim 1, wherein rapid solidification occurs via spray forming.

27. The method according to Claim 1, wherein at least a first boride phase is formed in the homogeneous pre-alloyed powder material, and wherein the first boride phase is comprised of Co₃B or a mixture of Co₃B and Co₂B borides.

28. The method according to Claim 1, wherein the boride size is less than 2 µm.

29. The method according to Claim 1, wherein for the Co-(5-25 at. %)Cr-(5-25 at. %)Pt-(5-20 at. %)B-(0.2-7.5 at. %)*X₁* and optionally (0.5-7.5 at. %)*X₂* alloy system, a primary phase is formed in the homogeneous pre-alloyed powder material, wherein the primary phase is an extended solid solution comprised of Co-Cr-*X₁*-Pt or Co-Cr-*X₁-X₂*-Pt.

30. The method according to Claim 29, wherein the primary phase is an extended solid solution comprised of Co-Cr-*X₁-*Pt or Co-Cr-*X₁-X₂*-Pt containing up to 2 at. % silver (Ag) or up to 7.5 at % gold (Au), or up to 7.5 at. % copper (Cu).

31. A method of manufacturing a chromium (Cr)-based sputter target formulated as Cr-(2-20 at. %)B or Cr-(2-20 at. %)C, the method comprising the steps of:
preparing a plurality of raw materials into a composition corresponding to a Cr-(7-20 at. %)B or Cr-(5-25 at. %)C alloy system, the plurality of raw materials comprising pure elements or master alloys;
heating the plurality of raw materials under vacuum or under a partial pressure of argon (Ar) to a fully liquid state to form a molten alloy corresponding to the Cr-(7-20 at. %)B or Cr-(5-25 at. %)C alloy system;
solidifying the molten alloy to form an ingot;
reheating the ingot to a fully liquid state to form a diffuse molten alloy;
rapidly solidifying the diffuse molten alloy into a homogeneous pre-alloyed powder material;
consolidating the homogeneous pre-alloyed powder material into a fully dense homogeneous material corresponding to blend composition of Cr-(2-20 at. %)B or Cr-(2-20 at. %)C; and
machining the fully dense homogenous material to form a sputter target.

32. The method according to Claim 31, further comprising the step of admixing pure elemental chromium (Cr) powder to the homogeneous pre-alloyed powder material.

33. The method according to Claim 31, wherein the homogeneous Cr-(2-20 at. %)B pre-alloyed powder material has a microstructure comprised of a supersaturated chromium (Cr) solid solution and/or a supersaturated chromium (Cr) solid solution with sub-micron Cr₂B borides.

34. The method according to Claim 31, wherein the homogeneous Cr-(2-20 at. %)C pre-alloyed powder material has a microstructure comprised of a supersaturated chromium (Cr) solid solution with sub-micron Cr₂₃C₆ carbides.

35. A method of manufacturing an iron (Fe)-based sputter target formulated as Fe-(5-40 at. %)Co-(5-20 at. %)B, Fe-(5-90 at. %)Ni, Fe-(5-70 at. %)Co, Fe-(30-50 at. %)Pt, or Fe-(30-55 at. %)Pd, the method comprising the steps of:
preparing a plurality of raw materials into a composition corresponding to an Fe-(5-40 at. %)Co-(5-20 at. %)B, Fe-(5-90 at. %)Ni, Fe-(5-70 at. %)Co, Fe-(30-50 at. %)Pt, or Fe-(30-55 at. %)Pd alloy system, the plurality of raw materials comprising pure elements or master alloys;
heating the plurality of raw materials under vacuum or partial pressure of argon (Ar) to a fully liquid state to form a molten alloy corresponding to the Fe-(5-40 at. %)Co-(5-20 at. %)B, Fe-(5-90 at. %)Ni, Fe-(5-70 at. %)Co, Fe-(30-50 at. %)Pt, or Fe-(30-55 at. %)Pd alloy system;
solidifying the molten alloy to form an ingot;
reheating the ingot to a fully liquid state to form a diffuse molten alloy;
rapidly solidifying the diffuse molten alloy into a homogeneous pre-alloyed powder material;
consolidating the homogeneous pre-alloyed powder material into a fully dense homogeneous material;
hot rolling the fully dense homogeneous material; and
machining the fully dense homogenous material to form a sputter target.

36. The method according to Claim 35, wherein, for the Fe-(5-40 at. %)Co-(5-20 at. %)B alloy system, the fully dense homogeneous material is hot rolled at a temperature less then the solidus temperature.

37. The method according to Claim 35, wherein at least a first boride phase is formed in the homogeneous pre-alloyed powder material, and wherein the first boride phase is comprised of a metastable Fe₃B or a mixture of metastable Fe₃B and equilibrium Fe₂B borides.

38. A method of manufacturing a nickel (Ni)-based sputter target formulated as Ni-(10-50 at. %)P, the method comprising the steps of:
preparing a plurality of raw materials into a composition corresponding to a Ni-(10-50 at. %)P alloy system, the plurality of raw materials comprising pure elements or master alloys;
heating the plurality of raw materials under vacuum or partial pressure of argon (Ar) to a fully liquid state to form a molten alloy corresponding to the Ni-(10-50 at. %)P alloy system;
solidifying the molten alloy to form an ingot;
reheating the ingot to a fully liquid state to form a diffuse molten alloy;
rapidly solidifying the diffuse molten alloy into a homogeneous pre-alloyed powder material;
consolidating the homogeneous pre-alloyed powder material into a fully dense homogeneous material; and
machining the fully dense homogenous material to form a sputter target.

39. The method according to Claim 38, wherein the homogeneous pre-alloyed powder material has a microstructure comprised of a supersaturated nickel (Ni) solid solution with less than 10 µm Ni₃P phosphides.
